Europäisches Patentamt

European Patent Office

Office européen des brevets

(11) Publication number: **0 410 403 A1**

# EUROPEAN PATENT APPLICATION

(21) Application number: **90114221.6**

(22) Date of filing: **25.07.90**

(51) Int. Cl.⁵: **H01L 21/324**

(30) Priority: **26.07.89 IT 6762989**

(43) Date of publication of application:
**30.01.91 Bulletin 91/05**

(84) Designated Contracting States:
**DE FR GB IT NL SE**

(71) Applicant: **CSELT Centro Studi e Laboratori Telecomunicazioni S.p.A.**
**Via Guglielmo Reiss Romoli, 274**
**I-10148 Turin(IT)**

(72) Inventor: **Bernardi, Sergio**
**Via Chambery, 80/C**
**Torino(IT)**

(74) Representative: **Riederer Freiherr von Paar zu Schönau, Anton et al**
**Lederer, Keller & Riederer, Freyung 615,**
**Postfach 26 64 64**
**D-8300 Landshut(DE)**

(54) Method of protecting implanted gallium arsenide during annealing.

(57) The gallium arsenide substrate is placed in a reactor raised to high temperature by a furnace and near said substrate an arsenic overpressure is obtained by using as arsenic source a saturated solution of gallium arsenide in tin.

EP 0 410 403 A1

## METHOD OF PROTECTING IMPLANTED GALLIUM ARSENIDE DURING ANNEALING

The present invention concerns the processes of fabricating high-speed solid-state electronic and optoelectronic devices and more particularly a method of protecting implanted gallium arsenide during annealing.

To date, gallium arsenide, GaAs, is one of the best known and most-widely used semiconductors for the industrial fabrication of devices operating at high frequency and high power, as needed, for instance, in radar systems or in radiomobile apparatus.

The characteristic which renders this compound particularly apt to be used in fast devices is its high electron mobility, which is about 100 times higher than silicon mobility. Another positive characteristic is its high dielectric constant, allowing high density integrated circuits to be fabricated by ion implantation methods.

Said methods allow easy fabrication of planar arrays ot even highly-complex devices owing to the possibility of selectively doping the substrate both as geometry and quality of the material. A typical process of ion implantation consists of the production of ions and in their acceleration in direction of a target which is a semiconducting gallium arsenide substrate, having generally the shape of a disc with a diameter equal to or longer than two inches. As an effect of the obtained energy, ions penetrate the substrate endowing the interested zones with particular electrical properties, dependent on the ionic species used and on the implantation energy.

Yet, the method of ion implantation into the substrate lattice entails also so severe a damaging phenomenon of the same lattice that the dopant transport properties of the damaged substrate exceed those of the just implanted material. As a consequence, ion implanted material can be used if the crystal lattice, rendered amorphous by ion bombardment, is submitted to a solid state reconstruction, avoiding as far as possible the diffusion of the implanted species. In fact, the objective of ion-implantation methods is that of achieving a planar distribution of zones of semiconductor with electric properties locally well defined and aimed at the device design.

A thermally activated process, named annealing, can be used to reduce implantation-derived structure damages and to emphasize the electrical properties of the implanted dopants. In this process, atoms are submitted to a readjustment capable of recovering structure conditions similar to those preceding ion implantation. Thermal energy supplies vibrational energy sufficient to build again interatom bonds and to obtain single-crystal conditions.

Since during said thermal processes rather high temperatures are attained, GaAs stoichiometry is to be maintained. In fact were the compound be submitted to thermal annealing cycles without precautions, it would heavily degrade for high arsenic loss, with consequent physical (thermal etching) and electrical damages, and would be rendered absolutely unsuited to fabrication of electronic devices.

The method universally used to keep GaAs stoichiometry is that of starting thermal annealing in the presence of a conditioning atmosphere wherein arsenic overpressure is obtained, generated by sources different from the substrate. Thus the generation of Ga and As by GaAs dissociation is avoided.

Some methods designed to obtain said arsenic overpressure during GaAs thermal annealing are known from the literature.

A method described in the paper entitled "Capless anneal of ion-implanted GaAs in controlled arsenic vapour", by J. Kasahara et alii, issued on the Journal of Applied Physics, January 1979, consists of injecting arsine ($AsH_3$) into the reactor, wherein annealing occurs. At the operating temperature such a compound decomposes to arsenic and hydrogen, thus producing the overpressure necessary to hinder the loss of arsenic from GaAs during the annealing step.

Yet this method presents a disadvantage, in fact, it needs reactors, and laboratories housing them, equipped with considerable security means to prevent even minimum leakages of the used material.

In fact arsine is a powerful hemolytic substance with very low tolerance limits, requiring reactors insulated from working premises and uninterrupted surveillance with sensor banks. However risks are not annulled by said expensive precautions, which are more expensive than the reactor. The personnel in fact are to submit to continuous checkups.

In numerous laboratories that makes it impossible to implement the method, not only due to the cost and complexity of security apparatus, but also due to lack of personnel availability or authorization by public boards entrusted with accident prevention.

Said disadvantages are overcome by the method of protecting implanted gallium arsenide during thermal amnnealing, provided by the present invention, which uses non-toxic materials, so it can be implemented in any factory or laboratory.

The present invention provides a method of protecting implanted gallium arsenide during annealing, wherein a gallium arsenide substrate is placed into a reactor, raised to high temperature by a furnace, characterized in that near that substrate an arsenic overpressure is generated by using as arsenic source a saturated solution of gallium arsenide in tin.

Said and other characteristics of the present invention will be made more evident by the following description of a preferred way of embodiment thereof, given by way of a non-limiting example, and by the annexed drawing in which a reactor is depicted containing the implanted substrate to be annealed.

In the present invention too, GaAs decomposition to Ga and As is avoided by annealing the substrate, which was submitted to ion implantation process, in a reactor where As overpressure was generated. The difference being that as an As source a saturated solution of gallium arsenide in tin is used. In fact from an ideal point of view, a supersaturated solution of gallium arsenide in tin and a gallium-arsenide single-crystal slightly impoverished by arsenic losses are comparable, since gallium-arsenide single-crystal, under said off-stoichiometry conditions, can be considered as an oversaturated solution of GaAs in Ga.

As known, equilibrium partial pressure of a soluted species, contained in a certain solution, is linearly dependent on its concentration and on its activity coefficient. As to GaAs dissolved into Sn, the product of activity coefficient for the concentration is greater than the corresponding product relevant to GaAs dissolved in Ga at the same temperature, even when said temperature reaches 800-900 $^\circ$C values, typical of the annealing process. The consequence is that arsenic pressure generated by a solution of GaAs in Sn can bring the equilibrium of decomposition of GaAs single crystal towards the molecular form.

During the process there is only production of gaseous arsenic, which as known, is extremely less toxic than arsine. Besides, at room temperature, i.e. in the conditions the samples are introduced into or extracted from the reactor, the arsenic pressure inside the reactor is similar to that lying on the single crystal of GaAs, i.e. null.

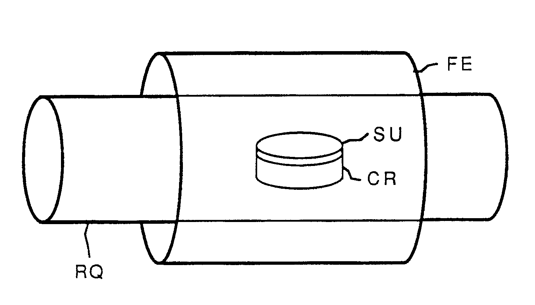

The annealing process takes place inside a quartz reactor, denoted by RQ in the Figure, surrounded by an electrical resistive furnace FE, apt to raise the internal temperature to a value ranging from 800 to 900 $^\circ$C.

Inside the reactor there is a graphite crucible CR containing the saturated solution of GaAs in tin, covered with substrate SU to be annealed, which acts as a cap. The implanted substrate base faces the solution surface. This arrangement allows maximum protection of stoichiometry of the substrate in GaAs by the solution.

The reactor atmosphere consists of a slight flow of over-pure hydrogen at atmospheric pressure.

The solution of GaAs in tin is prepared by melting tin solvent in the presence of a quantity of polycrystalline GaAs sufficient to ensure saturation. Once prepared, the solution can be used many times still keeping its supersaturation by a little excess of soluted polycrystalline GaAs.

It is clear that what described has been given only by way of non-limiting example. Variations and modifications are possible without going out from the scope of the claims.

## Claims

1. A method of protecting implanted gallium arsenide during annealing, wherein gallium arsenide substrate (SU) is placed into a reactor (RQ) raised to high temperature by a furnance (FE) characterized in that near said substrate (SU) an arsenic overpressure is generated by using as arsenic source a saturated solution of gallium arsenide in tin.

2. A method as in claim 1, characterized in that said solution of gallium arsenide in tin is placed in a crucible (CR), closed by the substrate (SU) to be annealed, acting as a cap and whose implanted base faces the saturated solution surface.

3. A method as in claim 1 or 2, characterized in that said solution of gallium arsenide in tin is supersaturated.

FE

SU

CR

RQ

European
Patent Office

**EUROPEAN SEARCH
REPORT**

Application Number

**EP 90 11 4221**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | IEEE ELECTRON DEVICE LETTERS, vol. EDL-7, no. 1, January 1986, pages 23-25; F.C. PRINCE et al.: "Application of a solution proximity annealing technique for fabrication of ion-implanted GaAs integrated circuits" <br> * Whole document * | 1-3 | H 01 L 21/324 |
| A | APPLIED PHYSICS LETTERS, vol. 48, no. 23, 9th June 1986, pages 1623-1625, New York, US; C.A. ARMIENTO et al.: "Capless rapid thermal annealing of GaAs using an enhanced overpressure proximity technique" <br> * Whole document * | 1-3 | |
| A | JOURNAL OF THE ELECTROCHEMICAL SOCIETY, vol. 134, no. 8A, August 1987, pages 2010-2016; C.A. AR-MIENTO et al.: "Capless rapid thermal annealing of GaAs implanted with Si using an enhanced overpressure proximity method" <br> * Pages 2010-2011 * | 1-3 | |
| A | EP-A-0 226 311 (GTE LAB. INC.) <br> * Abstract * | 1-3 | |

TECHNICAL FIELDS
SEARCHED (Int. Cl.5)

H 01 L

The present search report has been drawn up for all claims

| Place of search | Date of completion of search | Examiner |
|---|---|---|
| The Hague | 26 October 90 | GELEBART J.F.M. |

CATEGORY OF CITED DOCUMENTS

X : particularly relevant if taken alone
Y : particularly relevant if combined with another
document of the same catagory
A : technological background
O : non-written disclosure
P : intermediate document
T : theory or principle underlying the invention

E : earlier patent document, but published on, or after
the filing date
D : document cited in the application
L : document cited for other reasons

& : member of the same patent family, corresponding
document